# EUROPEAN PATENT APPLICATION

(11) **EP 2 660 225 A1**
(43) Date of publication of application: **06.11.2013**
(21) Application number: 11853630.9
(22) Date of filing: 15.07.2011
(51) Int. Cl.: C04B 41/87, C01B 31/30, C01B 31/34, C04B 35/52

(54) **CARBON MATERIAL, JIG, AND METHOD FOR PRODUCING CARBON MATERIAL**

(30) Priority: 27.12.2010 JP 2010289642
(71) Applicant: Toyo Tanso Co., Ltd., Osaka-shi, Osaka 555-0011 (JP)
(72) Inventor: SETANI, Kaoru, Kanonji-shi Kagawa 769-1612 (JP); MATSUNAGA, Hiroaki, Kanonji-shi Kagawa 769-1612 (JP); TAKEDA, Akiyoshi, Kanonji-shi Kagawa 769-1612 (JP)
(74) Representative: Glawe, Delfs, Moll
(86) International application number: PCT/JP2011/066182
(87) International publication number: WO 2012/090535

(57) **Abstract**

A carbon material, a jig, and a method of manufacturing the carbon material are provided that can prevent dust emission and also improve the temperature resistance under a nitrogen atmosphere. In a carbon material having a carbon substrate and a metal carbide layer formed on a surface of the carbon substrate, the metal carbide layer includes molybdenum carbide and/or iron carbide. The carbon substrate embedded in a surface modifying agent containing a pyrolytic hydrogen halide generating agent and molybdenum particles and/or iron particles is heat-treated together with a carbon member other than the carbon substrate.

## Description

### TECHNICAL FIELD

The present invention relates to a carbon material, a jig, and a method of manufacturing a carbon material, and more particularly to a carbon material, a jig, and a method of manufacturing a carbon material that are capable of preventing impurity emission and improving the temperature resistance under a nitrogen atmosphere.

### BACKGROUND ART

Carbon materials are light in weight and excellent in chemical and thermal stability. However, their uses are limited in, for example, semiconductor manufacturing processes because they have dust emission characteristics.
In view of the problem, it has been proposed that, as shown in Patent Documents 1 and 2 listed below, a chromium carbide layer composed of Cr₂₃C₆ is provided on the surface of a carbon substrate by treating the carbon substrate with a chromium halide gas, and the chromium carbide layer is coated by thermal spraying with a metal. However, this technique has the following problems. It takes a long time to form a layer comprising Cr₂₃C₆ that can withstand the thermal spraying of a metal. Also, the treatment is complicated and troublesome; for example, it is essential to carry out the treatment in a hydrogen gas atmosphere and the treatment needs to be performed under a reduced pressure.

In view of the problem, a technique has been proposed, as shown in Patent Document 3, in which a carbon substrate is heat-treated together with a carbon member other than the carbon substrate, the carbon substrate embedded in a surface modifying agent comprising a pyrolytic hydrogen halide generating agent and a metal particulate material containing a transition metal.

### CITATION LIST

### Patent Literature

[Patent Document 1] Japanese Published Unexamined Patent Application No. H08(1996)-143384 A
[Patent Document 2] Japanese Published Unexamined Patent Application No. H08(1996)-143385 A
[Patent Document 3] Japanese Published Unexamined Patent Application No. 2010-132518 A

### SUMMARY OF INVENTION

### TECHNICAL PROBLEM

In the above-mentioned semiconductor manufacturing process or the like, various kinds of treatments may be performed in a nitrogen atmosphere. For this reason, the metal carbide layer that covers the carbon substrate needs to have excellent temperature resistance under a nitrogen atmosphere. However, merely forming a transition metal on the carbon substrate surface as shown in the above-mentioned Patent Document 3 does not necessarily improve the temperature resistance under a nitrogen atmosphere.

In view of the foregoing problems, it is an object of the present invention to provide a carbon material and a method of manufacturing the carbon material that can prevent dust emission and also improve the temperature resistance under a nitrogen atmosphere.

### SOLUTION TO PROBLEM

In order to accomplish the foregoing object, the present invention provides a carbon material comprising a carbon substrate and a metal carbide layer formed on a surface of the carbon substrate, characterized in that the metal carbide layer comprises molybdenum carbide and/or iron carbide. It should be noted that the phrase "the metal carbide layer comprises molybdenum carbide and/or iron carbide" means that the amount of molybdenum and/or iron is 90 weight % or greater in the metal components in the metal carbide layer, and it is preferable that the amounts of other metals are at such levels that they are almost not detected in X-ray diffraction.
Since the metal carbide layer is formed on the carbon substrate surface as in the foregoing configuration, dust emission can be inhibited. Moreover, since the metal carbide layer is composed of molybdenum carbide and/or iron carbide, the temperature resistance under a nitrogen atmosphere can be improved.

It is desirable that the metal carbide layer comprise molybdenum carbide.
The reason is that molybdenum carbide shows higher temperature resistance under a nitrogen atmosphere than iron carbide.

It is desirable that the metal carbide layer be a layer formed by causing a metal and the carbon on the surface of the carbon substrate with each other.

In order to accomplish the foregoing object, the present invention also provides a jig used under a nitrogen atmosphere, characterized in that a metal carbide layer is formed on a carbon substrate, the metal carbide layer comprising molybdenum carbide and/or iron carbide.
It is desirable that the metal carbide layer comprise molybdenum carbide, and it is desirable that the metal carbide layer be a layer formed by causing a metal and the carbon on the surface of the carbon substrate with each other.

In order to accomplish the foregoing object, the present invention also provides a method of manufacturing a carbon material, characterized by heat-treating a carbon substrate together with a carbon member other than the carbon substrate, the carbon substrate embedded in a surface modifying agent containing a pyrolytic hydrogen halide generating agent and molybdenum particles and/or iron particles.
With the above-described method, the above-described carbon material can be manufactured easily and at low cost. Specifically, the details are as follows.

Usable methods of manufacturing the metal carbide layer comprising molybdenum carbide or iron carbide include an evaporation method and a CVD method. The evaporation method and the CVD method requires a vacuum facility that can perform deoxidization precisely because molybdenum and iron, used as the raw materials, can be easily oxidized, and in particular, molybdenum can be oxidized even at room temperature. Moreover, when a halogenated compound is used in the evaporator apparatus and the CVD apparatus, a scrubber facility also becomes necessary. Furthermore, the evaporation method and the CVD method are such that a film is newly formed on a substrate, so the adhesion of the film with the substrate is poor and it is difficult to form the film over the entire surface of a substrate with a complicated shape.
For these reasons, the materials on which molybdenum carbide or iron carbide is formed on a carbon material have necessitated high manufacturing cost and have not been sufficient in terms their characteristics, so they have been difficult to put into practical use.

On the other hand, when using the above-described manufacturing method (CVR method), the metal carbide layer comprising molybdenum carbide or iron carbide can be formed on the carbon substrate without using the vacuum facility and the like. This metal carbide layer is such a layer that a metal and the carbon on the surface of the carbon substrate have reacted with each other and thereby the surface have been modified, and it shows very high adhesion and does not easily peel off. In addition, even when using molybdenum, which tends to be oxidized easily, the molybdenum or the like can be easily reduced by a heat treatment even if the molybdenum or the like is oxidized, because the carbon substrate and the carbon member used in the CVR method (a container made of a carbon material and carbon powder, which will be mentioned later) contain carbon. Thus, the metal carbide layer comprising molybdenum carbide or iron carbide can be easily formed on the surface of the carbon substrate.

It is desirable that the surface modifying agent comprise the pyrolytic hydrogen halide generating agent and the molybdenum particles.
With such a method, molybdenum carbide, which has higher temperature resistance under a nitrogen atmosphere than iron carbide, is formed on the surface of the carbon substrate.

### ADVANTAGEOUS EFFECTS OF INVENTION

According to the present invention, a metal carbide layer comprising molybdenum carbide or iron carbide is formed on a surface of a carbon substrate. Therefore, the present invention makes it possible to inhibit dust emission and at the same time improve the temperature resistance under a nitrogen atmosphere. Moreover, the present invention makes it possible to form the metal carbide layer at low cost.

### BRIEF DESCRIPTION OF DRAWINGS

[Fig. 1] Fig. 1 is a diagram illustrating one example of an apparatus used in the method of manufacturing a carbon material described in the present invention.
[Fig. 2] Fig. 2 is a graph showing an X-ray diffraction chart for a present invention material A and a comparative material Z.

### DESCRIPTION OF EMBODIMENTS

Hereinbelow, the present invention will be described in detail.
The carbon material according to the invention is a carbon material comprising a carbon substrate and a metal carbide layer, formed on a surface of the carbon substrate, comprising molybdenum carbide and/or iron carbide. This metal carbide layer is such a layer that a metal and the carbon on the surface of the carbon substrate have reacted with each other and thereby the surface have been modified. The method of manufacturing the carbon material involves heat-treating a carbon substrate together with a carbon member other than the carbon substrate, the carbon substrate embedded in a surface modifying agent (in a powdery state) comprising a pyrolytic hydrogen halide generating agent and metal particles comprising molybdenum or iron (more desirably, the metal particles contain only molybdenum or iron).

In the method of manufacturing the carbon material of the present invention, the carbon substrate to be treated is heat-treated together with a carbon member other than the carbon substrate. Examples of the carbon member include a container made of carbon, such as a graphite crucible, and carbon powder. By heat-treating the carbon substrate to be treated together with the carbon member in this way, a metal carbide layer can be formed on the carbon substrate in a short time. The reason is believed to be that by using the carbon member, the materials contained in the powder, such as molybdenum, iron, and the pyrolytic hydrogen halide generating agent, can be utilized efficiently for the surface treatment of the carbon substrate, so the necessary heat amount can be reduced.
With a treatment time of less than 1 hour, the metal carbide layer can be formed without color unevenness and substantially uniformly on the carbon substrate. This metal carbide layer can sufficiently be formed with a treatment time of 30 minutes. The treatment time may be longer, for example, 1 hour or longer, if the metal carbide layer needs to be thicker.

It is preferable that the heat treatment be performed at from 800°C to 1500°C. By treating within this temperature range, the carbon substrate can be treated efficiently. If the temperature is too low, it is possible that the formation of the metal carbide layer may be slow. If the temperature is too high, it is possible that the powder that has not reacted in the heat treatment may be thermally melted and bonded to the carbon substrate.

It is preferable that the heat treatment be performed under normal pressure. Since the treatment can be performed under normal pressure, the equipment such as a vacuum pump is unnecessary, and the time required for reducing the pressure is also unnecessary. As a result, the treatment becomes simpler, and the treatment time reduces. Although it is possible to perform the treatment under reduced pressure, it may become difficult to cause an efficient reaction of hydrogen halide since the pyrolytic hydrogen halide generating agent may undergo violent decomposition at low temperature, and also, it is possible that the powder may scatter.

The method of manufacturing the carbon material of the present invention does not require introduction of hydrogen gas. Therefore, safety is improved, and the treatment can be conducted easily.

The carbon material according to the present invention can be provided with a metal layer formed on the metal carbide layer. In this case, it is possible to ensure good adhesion performance between the metal carbide layer and the layer of the metal or the like. Examples of the method of later forming the metal layer or the like on the metal carbide layer include plating and thermal spraying, and an example of the method that achieves particularly good adhesion performance is plating.

Hereinbelow, the components and members used in the present invention will be described.
Examples of the carbon substrate include, but not particularly limited to, isotropic graphite materials, anisotropic graphite materials, and carbon fiber materials. It is preferable that the carbon substrate have a bulk density of from 1.4 g/cm³ to 2.1 g/cm³, an average pore radius of 10 µm or less, and a porosity of 40% or less.

The pyrolytic hydrogen halide generating agent is such that is kept in a solid state under room temperature and normal pressure but is decomposed by heating to generate a hydrogen halide such as hydrogen chloride, hydrogen fluoride, and hydrogen bromide. It is preferable that the heat decomposition temperature of the pyrolytic hydrogen halide generating agent be 200°C or higher, so that the handling before the heating can be easy. The hydrogen halide generated from the pyrolytic hydrogen halide generating agent reacts with molybdenum or iron during the heat treatment and produces a metal halide gas. By treating the carbon substrate with the metal halide gas, the metal carbide layer can be formed on a surface of the carbon substrate. Since the treatment of the carbon substrate is conducted with gas as described above, the metal carbide layer can be formed substantially uniformly on the carbon substrate even when the carbon substrate has a complicated shape with, for example, holes and grooves.
It is preferable that the pyrolytic hydrogen halide generating agent be ammonium chloride from the viewpoint of availability.

Examples of the carbon member include a container made of carbon, such as a graphite crucible, and carbon powder.
With the use of the carbon member, the treatment time of the carbon substrate can be shortened, and the need of the hydrogen gas supply can be eliminated. As a result, the surface modification of the carbon substrate can be achieved in a simpler manner and more easily. This makes it possible to improve the adhesivity of the carbon substrate with a layer of a metal or the like that is to be later formed on the surface, and also to improve the strength of the resulting carbon material over the carbon substrate. Moreover, pressure reduction is not needed, and the heat treatment can be conducted under normal pressure (in an atmospheric pressure). Thus, the treatment can be conducted in a simple manner.

It is preferable that the carbon member be a graphite crucible. The use of a graphite crucible in the treatment makes it possible to suppress the flow of the gas around the embedded carbon substrate, and to form the metal carbide layer without color unevenness and more uniformly on the surface of the carbon substrate. Moreover, the gas produced from the powder can be kept in the graphite crucible to a certain degree, so the produced gas can be utilized effectively. It is preferable that a lid be placed on the graphite crucible, and the lid serves to further suppress the flow of the gas around the carbon substrate. Examples of the lid include one made of graphite, and a sheet made of graphite. In order to release the gas produced in the container, it is preferable that an air hole be provided in the container or in the lid. When using a sheet made of graphite, the air hole is not particularly necessary since the sheet merely covers the container.

When using carbon powder as the carbon member, it is recommended that the metal particles comprising molybdenum or iron, the pyrolytic hydrogen halide generating agent, and the carbon powder be filled in the container, the carbon substrate be embedded in the powder filled in the container, and the carbon substrate be heat-treated. When using carbon powder as the carbon member, the container is not particularly limited. In the treatment, it is possible to suppress the flow of the gas in the container by, for example, putting a lid or a sheet made of graphite on the container. It is also possible to use the above-mentioned graphite crucible as the container.

As described above, an introduced gas is not directly blown into the container in which the carbon substrate is embedded. Conversely, if an attempt is made to carry out the treatment while introducing a hydrogen gas, it is difficult to efficiently perform the treatment using the hydrogen gas because the container, such as the graphite crucible, hinders the introduction of hydrogen gas.

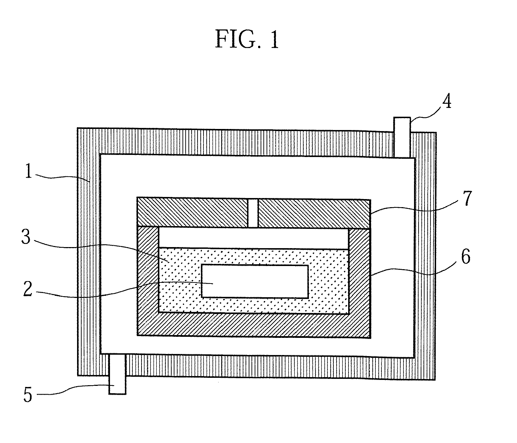

Next, one example of the heating apparatus for carrying out the heat treatment in the method of manufacturing the carbon material of the present invention will be described with reference to Fig. 1. The following description is made about a case in which a graphite crucible is used as the carbon member.
As illustrated in Fig. 1, a heating apparatus used in the method of manufacturing the carbon material of the present invention (the present heating apparatus) has a heating furnace 1 having a heater for heat-treating a treatment material placed in the heating furnace 1. The heating furnace 1 is provided with a gas inlet port 4 and a gas exhaust port 5. An inert gas such as nitrogen gas and argon gas can be introduced from the gas inlet port 4, as necessary.

In the present heating apparatus, a graphite crucible 6 is disposed in the heating furnace 1. The graphite crucible 6 is configured so that powder 3 (surface modifying agent) can be filled in the graphite crucible 6, a carbon substrate 2 to be treated can be embedded in the powder 3, and further, a lid 7 can be placed on the graphite crucible 6. The lid 7 has an air hole. The powder 3 contains a pyrolytic hydrogen halide generating agent and metal powder (metal particles) comprising molybdenum or iron. It is possible to add alumina powder, which is not involved in the reaction, to the powder 3.

With the heating apparatus of Fig. 1, the powder 3 is filled in the graphite crucible 6 as the carbon member, the carbon substrate 2 is embedded in the powder 3 filled in the crucible, and the crucible is closed with the lid 7. Then, the graphite crucible 6 is placed in the heating apparatus and heated. With the above-described configuration, the method of manufacturing the carbon material of the present invention can be implemented.

The carbon material of the present invention has a metal carbide layer comprising Mo₂C and/or Fe₃C on the carbon substrate. It is preferable that the maximum thickness of the metal carbide layer be 100 µm or less. On the other hand, when the minimum thickness of the metal carbide layer exceeds 0 µm, the advantageous effects of the present invention can be exhibited. Nevertheless, in order to obtain the advantageous effects more sufficiently, it is desirable that the minimum thickness be 0.5 µm or greater. In addition, it is more preferable that the metal carbide layer have a thickness of from 1 µm to 50 µm. The reason is as follows. If the thickness of the metal carbide layer is less than 1 µm, it is difficult to modify the entire surface of the carbon to be treated. On the other hand, if the thickness of the metal carbide layer exceeds 50 µm, the dimensional change of the finally produced carbon material becomes too great, so the dimensional control is difficult.

The amount of molybdenum or iron needs to be changed according to the surface area of the carbon substrate, but it is preferable that amount of molybdenum or iron be restricted to about 0.3 g to about 0.6 g per 1 cm² of the carbon substrate. The reason is that when the amount is restricted in this way, the metal carbide layer having such a film thickness as mentioned above can be obtained.

In addition, when molybdenum powder is used as the metal powder and ammonium chloride is used as the pyrolytic hydrogen halide generating agent, it is preferable that the weight ratio of the ammonium chloride to the molybdenum powder be restricted to 0.05-0.30 : 1. Likewise, when iron powder is used as the metal powder and ammonium chloride is used as the pyrolytic hydrogen halide generating agent, it is preferable that the weight ratio of the ammonium chloride to the iron powder be restricted to 0.05-0.30 : 1. The reason is as follows. If the amount of the ammonium chloride powder is too low, the metal carbide layer film is not generated sufficiently on the carbon substrate. On the other hand, if the amount of the ammonium chloride powder is too high, the hydrogen halide is generated excessively, so that the metal carbide layer is not generated sufficiently on the carbon substrate.

It is also possible to perform a further heat treatment after the formation of the metal carbide layer to thereby stabilize the metal carbide layer. It is recommended that this heat treatment be performed in a reducing gas atmosphere such as a hydrogen gas at a temperature of from 500°C to 1500°C for about 30 minutes.

It should be noted that the carbon material of the present invention can suitably be used as a jig. A jig is demanded to have various shapes. Since a carbon substrate is processed easily, the carbon substrate may be processed in a desired shape in advance, and then treated in the manner described above to form a molybdenum carbide and/or iron carbide layer, so that the jig can be easily manufactured. In the above-described method, since the treatment of the carbon substrate is conducted with a gas, the metal carbide layer can be formed substantially uniformly on the carbon substrate even when the carbon substrate has a complicated shape with, for example, holes and grooves. The resulting jig has excellent nitrogen resistance and therefore can be suitably used under a nitrogen atmosphere such as in a semiconductor manufacturing process.

### EXAMPLES

Hereinbelow, the present invention will be described in further detail based on examples thereof. However, the present invention is not limited thereto.

### Example 1

Using an apparatus shown in Fig. 1, a mixture powder of molybdenum powder (17 g), ammonium chloride (NH₄Cl) powder (2.8 g), and alumina (Al₂O₃) powder (17 g) was filled in a graphite crucible (made by Toyo Tanso Co., Ltd, Model number IG-11), and a carbon substrate (high-density isotropic graphite subjected to cold isotropic pressure forming: bulk density 1.8, average pore radius 5 µm, porosity 20%) having dimensions of 10 mm wide × 60 mm long × 10 mm thick was embedded in the mixture powder filled in the crucible. The crucible was placed in a heating furnace with a lid put thereon, and a heat treatment was performed at 1200°C for 30 minutes. When heating, nitrogen was introduced from the gas inlet port, and the gas was discharged naturally from the gas exhaust port. Thus, a carbon material in which a metal carbide layer comprising molybdenum carbide was formed on the surface of the carbon substrate was obtained. The film thickness of the metal carbide layer was 5 µm.
The carbon material fabricated in this manner is hereinafter referred to as a present invention material A1.

### Example 2

A carbon material was fabricated in the same manner as described in Example 1 above, except that the amount of the ammonium chloride powder was set at 1.4 g. Thus, a carbon material in which a metal carbide layer comprising molybdenum carbide was formed on the surface of the carbon substrate was obtained. The film thickness of the metal carbide layer was 5 µm.
The carbon material fabricated in this manner is hereinafter referred to as a present invention material A2.

### Example 3

A carbon material was fabricated in the same manner as described in Example 1 above, except that the amount of the ammonium chloride powder was set at 5.6 g. Thus, a carbon material in which a metal carbide layer comprising molybdenum carbide was formed on the surface of the carbon substrate was obtained. The film thickness of the metal carbide layer was 5 µm.
The carbon material fabricated in this manner is hereinafter referred to as a present invention material A3.

### Example 4

A carbon material was fabricated in the same manner as described in Example 1 above, except that iron powder (17 g) was used in place of the molybdenum powder and the heat treatment temperature was set at 1100°C. Thus, a carbon material in which a metal carbide layer comprising iron carbide was formed on the surface of the carbon substrate was obtained. The film thickness of the metal carbide layer was 2 µm.
The carbon material fabricated in this manner is hereinafter referred to as a present invention material A4.

### Comparative Example 1

A carbon material was fabricated in the same manner as described in Example 1 above, except that chromium powder (17 g) was used in place of the molybdenum powder and the heat treatment temperature was set at 800°C. Thus, a carbon material in which a metal carbide layer comprising chromium carbide was formed on the surface of the carbon substrate was obtained. The film thickness of the metal carbide layer was 2 µm.
The carbon material fabricated in this manner is hereinafter referred to as a comparative material Z1.

### Comparative Example 2

A carbon material was fabricated in the same manner as described in Example 1 above, except that stainless steel powder (SUS 316 powder) was used in place of the molybdenum powder and the heat treatment temperature was set at 1000°C. Thus, a carbon material was obtained in which a metal carbide layer comprising carbide of the metals that constitute the stainless steel was formed on the surface of the carbon substrate. The film thickness of the metal carbide layer was 5 µm.
The carbon material fabricated in this manner is hereinafter referred to as a comparative material Z2.

### Experiment

The present invention materials A1 through A4 as well as the comparative materials Z1 and Z2 were annealed under a nitrogen atmosphere at 300°C, 500°C, and 1000°C, to observe whether the surface of each of the carbon materials showed discoloration. The results are shown in Table 1.

**[TABLE 1]**

| Material | Metal material | Annealing temperature under a nitrogen atmosphere | | |
|---|---|---|---|---|
| | | 300°C | 500°C | 1000°C |
| Present invention material A1 | Mo | Not discolored | Not discolored | Not discolored |
| Present invention material A2 | Mo | Not discolored | Not discolored | Not discolored |
| Present invention material A3 | Mo | Not discolored | Not discolored | Not discolored |
| Present invention material A4 | Fe | Not discolored | Not discolored | Not discolored |
| Comparative material Z1 | Cr | Discolored | - | - |
| Comparative material Z2 | SUS | Not discolored | Discolored | - |

As clearly seen from Table 1 above, the comparative material Z1, which used chromium as the metal material, showed discoloration at 300°C, and the comparative material Z2, which used stainless steel as the metal material, showed discoloration at 500°C. In contrast, the present invention materials A1 through A3, which used molybdenum as the metal material, as well as the present invention material A4, which used iron as the metal material, show no discoloration even at 1000°C. Moreover, the present invention materials A1 through A4 that were subjected to the annealing process under a nitrogen atmosphere did not cause dust emission or peeling of the metal carbide layer.

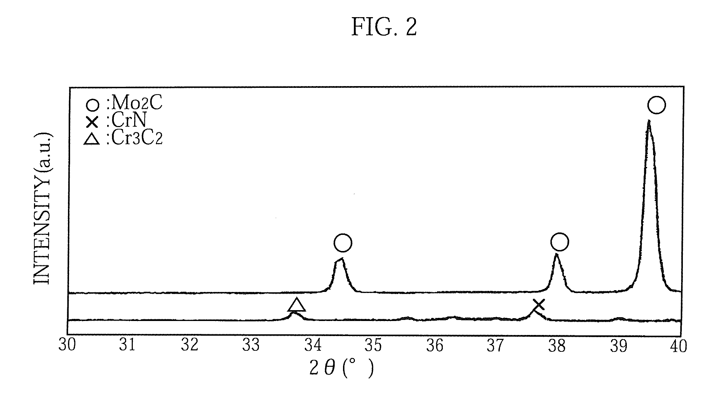

In order to investigate the reason, the X-ray diffraction was observed for the present invention material A1 that was subjected to the annealing process at 1000°C and the comparative material Z1 that was subjected to the annealing process at 300°C (equipment: X-ray diffractometer RINT2000 made by Rigaku Corp.). The results are shown in Fig. 2. In Fig. 2, the upper line of X-ray diffraction chart represents the present invention material A1, and the lower line of the X-ray diffraction chart represents the comparative material Z1.
As clearly seen from Fig. 2, it is observed that in the present invention material A1, only molybdenum carbide exists on the surface of the carbon substrate surface (i.e., molybdenum carbide is not nitrided), while in the comparative material Z1, chromium nitride as well as chromium carbide exists on the surface of the carbon substrate (i.e., chromium carbide is nitrided).

Thus, a problem with the comparative materials Z1 and Z2 is that the discoloration is caused by the annealing process in a nitrogen atmosphere, resulting in poor appearance, and in addition, another problem is that the metal carbide on the surface is nitrided and consequently is easily peeled. In contrast, the present invention materials A1 through A4 do not cause discoloration by the annealing process in a nitrogen atmosphere, so they can prevent these problems.

### INDUSTRIAL APPLICABILITY

The carbon material and the method of manufacturing the carbon material of the present invention can be used, for example, in the field of semiconductors. In particular, the carbon material of the present invention is a useful material for a jig used under a nitrogen atmosphere.

### REFERENCE SIGNS LIST

- 1: Furnace
- 2: Carbon substrate
- 3: Powder
- 4: Gas inlet port
- 5: Gas exhaust port
- 6: Graphite crucible
- 7: Lid

## Claims

1. A carbon material comprising a carbon substrate and a metal carbide layer formed on a surface of the carbon substrate, **characterized in that** the metal carbide layer comprises molybdenum carbide and/or iron carbide.

2. The carbon material according to claim 1, wherein the metal carbide layer comprises molybdenum carbide.

3. The carbon material according to claim 1 or 2, wherein the metal carbide layer is a layer formed by causing a metal and the carbon of the surface of the carbon substrate with each other.

4. A jig used under a nitrogen atmosphere, **characterized in that** a metal carbide layer is formed on a carbon substrate, the metal carbide layer comprising molybdenum carbide and/or iron carbide.

5. The jig according to claim 4, wherein the metal carbide layer comprises molybdenum carbide.

6. The jig according to claim 4 or 5, wherein the metal carbide layer is a layer formed by causing a metal and the carbon on the surface of the carbon substrate with each other.

7. A method of manufacturing a carbon material, **characterized by** heat-treating a carbon substrate together with a carbon member other than the carbon substrate, the carbon substrate embedded in a surface modifying agent containing a pyrolytic hydrogen halide generating agent and molybdenum particles and/or iron particles.

8. The method of manufacturing a carbon material according to claim 7, wherein the surface modifying agent comprises the pyrolytic hydrogen halide generating agent and the molybdenum particles.
